Europäisches Patentamt

European Patent Office

Office européen des brevets

(19)

(11) Veröffentlichungsnummer : **0 115 766**

**B1**

(12) # EUROPÄISCHE PATENTSCHRIFT

(45) Veröffentlichungstag der Patentschrift :
30.07.86

(21) Anmeldenummer : 84100034.2

(22) Anmeldetag : 17.12.80

(60) Veröffentlichungsnummer der früheren Anmeldung
nach Art. 76 EPÜ : 0031140

(51) Int. Cl.⁴ : **H 04 B   3/12,** H 03 F   3/19

(54) Gegengekoppelter Breitbandverstärker mit zwei gegengekoppelten Verstärkerblöcken.

(30) Priorität : 21.12.79 DE 2951913

(43) Veröffentlichungstag der Anmeldung :
15.08.84 Patentblatt 84/33

(45) Bekanntmachung des Hinweises auf die Patenterteilung : 30.07.86 Patentblatt 86/31

(84) Benannte Vertragsstaaten :
AT BE CH DE FR GB IT LI NL SE

(56) Entgegenhaltungen :
DE-B- 1 293 236
GB-A- 1 227 363
THE BELL SYSTEM TECHNICAL JOURNAL, Band 53,
Nr. 10, Dezember 1974, Seiten 1935-1985, USA E.H.
ANGELL et al.: "Repeatered line"
Idem.
NEC RESEARCH & DEVELOPMENT, Nr. 16, Januar
1970, Seiten 67-72, Tokyo, JP. K. TANAKA et al.: "A
study of 60 MHz line amplifier"
1976 NATIONAL TELECOMMUNICATIONS CONFE-
RENCE, Dallas, 29. November - 1. Dezember 1976,
Seiten 9.3-1 - 9.3-4, IEEE, New York, USA T.L. MADER:
"The fantastic balancing act - Undersea electronics
of the SG system"
FREQUENZ, Band 34, Nr. 6, Juni 1980, Seiten 169-175,
Berlin, DE. H. GÖLZ et al.: "Leitungsverstärker für
3600 Sprechkreise hoher Übertragungsqualität"

(73) Patentinhaber : **Siemens Aktiengesellschaft**
**Berlin und München Wittelsbacherplatz 2**
**D-8000 München 2 (DE)**

(72) Erfinder : **Bartenstein, Peter, Ing.grad**
**Ramsauer Strasse 19**
**D-8000 München 70 (DE)**
Erfinder : **Hübner, Franz Richard, Ing.grad**
**Blaichacherstrasse 6**
**D-8000 München 71 (DE)**
Erfinder : **Mocha, Karl, Dipl.-Ing.**
**Gut Deixlfurt Nr.4**
**D-8132 Tutzing (DE)**
Erfinder : **Göltz, Hubert, Dipl.-Ing.**
**Glatzer Strasse 17**
**D-8034 Germering (DE)**

## Beschreibung

Die Erfindung bezieht sich auf einen gegengekoppelten Breitbandverstärker, der aus zwei in Kette geschalteten, jeweils für sich gegengekoppelten Verstärkerblöcken besteht und bei dem die Verstärkung sowohl mit Hilfe eines ersten Stellgliedes in Abhängigkeit von der Länge des vorangehenden Verstärkerfeldes einstellbar als auch mit Hilfe eines zweiten Stellgliedes in Abhängigkeit von der Temperatur oder dem Pegel eines empfangenen Pilots steuerbar ist, wobei jeder der beiden Verstärkerblöcke eines der beiden Stellglieder enthält und das Stellglied jeweils im Gegenkopplungszweig des betreffenden Verstärkerblocks angeordnet ist.

Ein derartiger Breitbandverstärker ist bereits aus der DE-AS-1 293 236 bekannt.

Der bekannte Breitbandverstärker besteht aus einem Vorverstärker und einem Endverstärker. Beide Verstärkerblöcke sind mit Entzerrern versehen. Zwischen dem Vor- und dem Endverstärker ist ein Zusatzentzerrer eingefügt. Ein Temperaturentzerrer, der pilotgesteuert sein kann und ein Niveauregler sind im Endverstärker enthalten.

Bei dem bekannten Trägerfrequenz-Leitungsverstärker läßt sich die frequenzabhängige Verstärkung einstellen bzw. regeln oder steuern. Auf diese Weise kann man die Verstärkung an unterschiedliche Verstärkerfelddämpfungen und/oder durch die Temperatureinflüsse bedingte Dämpfungsänderungen des Kabels angleichen.

Mit einem Entzerrernetzwerk, das dem eigentlichen Verstärker in Kette geschaltet ist, läßt sich eine sogenannte Leitungsverlängerung erzielen. Mit Rücksicht auf die Geräuschbilanz und Aussteuerungsreserve bzw. Leistungsaufnahme der Verstärker ist diese Art der Leitungsverlängerung nur bei stark verkürzten Kabelfeldern und nur in groben Stufen zweckmäßig. Die Gegenkopplungsnetzwerke enthalten daher Entzerrer, so daß der gewünschte Ausgleich mittels Verstärkungsänderungen durch Änderungen im Gegenkopplungsnetzwerk des eigentlichen Verstärkers herbeigeführt wird.

Die insgesamt erforderlichen Verstärkungsänderungen sind aufgeteilt und zwar so, daß Änderungen der Verstärkerfelddämpfung im Vorverstärker und durch Änderungen der Temperatur bedingte Dämpfungsänderungen im Ausgangsverstärker ausgeglichen werden. Damit wird erreicht, daß bei einem temperaturgesteuerten Verstärker das temperaturgesteuerte Netzwerk vom temperaturunabhängigen Netzwerk entkoppelt und daher die Einstellung zum Angleichen an unterschiedliche Verstärkerfelddämpfungen vereinfacht ist.

Für den pilotgeregelten Verstärker wird zusätzlich erreicht, daß es beim Streckenaufbau zunächst mittels mehrerer Längenentzerrer an die jeweilige Kabellänge angeglichen werden kann und daß dann der volle Regelhub zum Ausgleich zeitlich veränderlicher Dämpfungsschwankungen zur Verfügung steht.

Aufgabe der Erfindung ist es, den Breitbandverstärker im Hinblick auf die benötigte Gleichstromleistung für den Fall weiter zu vervollkommen, daß Unterschiede der zeitlich mittleren Verstärkerfelddämpfung kleiner als die durch Temperatureinflüsse bedingten Dämpfungsänderungen mindestens eines vorangehenden Verstärkerfeldes sind. Insbesondere soll der Endverstärker für verschiedene Verstärkertypen, nämlich für Festverstärker mit festeingestellter Verstärkung, für temperaturgesteuerte Verstärker und/oder für pilotgeregelte Verstärker im wesentlichen unverändert übernommen werden können.

Gemäß der Erfindung wird der Breitbandverstärker zur Lösung dieser Aufgabe derart ausgebildet, daß der erste Verstärkerblock als temperatur- und/oder pilotgesteuerter Verstärker ausgebildet ist und daß der zweite Verstärkerblock das Stellglied zur Einstellung der Verstärkung in Abhängigkeit von der Länge des vorangehenden Verstärkerfeldes enthält.

Diesen Maßnahmen liegt die Erkenntnis zugrunde, daß einerseits die im Gegenkopplungsnetzwerk verbrauchte Signalleistung umso größer ist, je kleiner die Minimalverstärkung und je größer die einzustellende Verstärkungsvariation ist und andererseits beim Zweiblock-Verstärker für eine am Ausgang des Ausgangsverstärkers konstant vorgegebene Signalleistung die in der Endstufe des Vorverstärkers erforderliche Signalleistung umso größer ist, je kleiner die Verstärkung des Endverstärkers ist.

Da die kleineren Verstärkungsänderungen im Endverstärker vorgenommen werden, ergeben sich eine besonders kleine Signalleistung im Vorverstärker und ein besonders geringer Bedarf an Speiseleistung. Die Temperatursteuerung bzw. Pilotregelung im Vorverstärker hat zusätzlich den Vorteil, daß die zur Regelung bzw. Steuerung verwendeten Heißleiter oder anderen Steuer- und/oder Einstellelemente durch einen besonders niedrigen Signalpegel ausgesteuert werden und somit nichtlineare Verzerrungen infolge dieser an sich nichtlinearen Elemente weitestgehend vermieden sind.

Im Falle von größeren Unterschieden der Verstärkerfelddämpfung ist am Eingang des Breitbandverstärkers zweckmäßigerweise ein derart einstellbares Leitungsverlängerungsnetzwerk vorgesehen, daß die verbleibenden Unterschiede der Verstärkerfelddämpfung kleiner als die durch Temperatureinflüsse bedingten Dämpfungsänderungen des vorangehenden Verstärkerfeldes sind.

Dabei ergibt sich, daß der Variationsbereich der Verstärkung beim ersten Verstärkerblock größer ist als beim zweiten Verstärkerblock.

In Weiterbildung der Erfindung ist der Breitbandverstärker als Leitungsverstärker eines Trägerfrequenz-Übertragungssystems V3600 ausgebildet. Da bei dem Trägerfrequenz-Übertragungssystem V3600 der Planungswert der Felddämpfung hoch ist, sind auch die Dämpfungsänderungen infolge Temperaturänderungen entsprechend groß. Das ergibt die Forderung nach einem insgesamt großen Bereich für Verstärkungsänderungen insbesondere beim pilotgeregelten Verstärker, der gegebenenfalls die Dämpfungsänderungen mehrerer Felder ausgleichen muß. Dieser Ausgleich läßt sich mit Hilfe des Breitbandverstärkers vornehmen, ohne daß dabei ein unzulässig großer Leistungsbedarf erforderlich wäre.

Die Erfindung wird anhand der in den Figuren dargestellten Ausführungsbeispiele näher erläutert.

Es zeigen :

Figur 1 einen Breitbandverstärker, der aus einem Vorverstärker und einem Endverstärker zusammengesetzt ist und

Figur 2 weitere Einzelheiten des in Fig. 1 gezeigten Breitbandverstärkers.

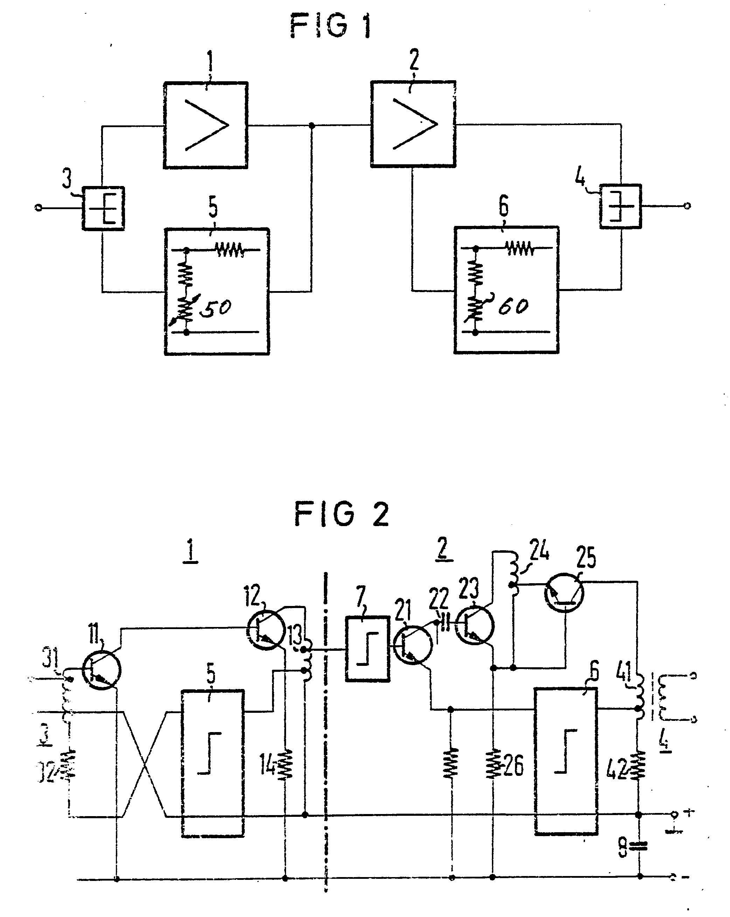

Der Breitbandverstärker nach Fig. 1 enthält den Vorverstärker 1 und den dazu in Kette geschalteten Endverstärker 2. Der Vorverstärker 1 ist über das Gegenkopplungsnetzwerk 5 gegengekoppelt. Der Endverstärker 2 ist über das Gegenkopplungsnetzwerk 6 gegengekoppelt, mit dessen Hilfe die Verstärkung an die Verstärkerfelddämpfung angepaßt werden kann.

Am Eingang und am Ausgang des Breitbandverstärkers ist jeweils ein Gabelübertrager 3 bzw. 4 vorgesehen, der den Ein- bzw. Ausgang vom Gegenkopplungsnetzwerk 5 bzw. 6 entkoppelt.

Das Gegenkopplungsnetzwerk 5 ist als Spannungsteiler ausgebildet, dessen Zweige komplexe Widerstände enthalten. Im Querzweig ist in Serie zu einem komplexen Widerstand ein steuerbarer ohmscher Widerstand 50 vorgesehen.

Bei Ausbildung des Breitbandverstärkers als Festverstärker wird an dieser Stelle ein fester ohmscher Widerstand eingesetzt. Soll der Breitbandverstärker dagegen als temperaturgesteuerter Verstärker dienen, so wird an dieser Stelle ein Widerstand mit vorgegebenen Temperaturkoeffizienten angebracht. Bei Ausbildung des Breitbandverstärkers als pilotgeregelter Verstärker ist an dieser Stelle ein steuerbarer Widerstand, insbesondere ein Heißleiter, Feldeffekttransistor, ein Diodenstellglied oder dgl. vorgesehen.

Das Gegenkopplungsnetzwerk 6 ist ebenfalls als Spannungsteiler ausgebildet, daß in beiden Zweigen jeweils einen komplexen Widerstand enthält. Im Querzweig ist ein stufenweise einstellbarer ohmscher Widerstand 60 vorgesehen, mit dessen Hilfe sich die Verstärkung stufenweise einstellen und somit an die Länge des vorangehenden Verstärkerfeldes angleichen läßt.

Bei dem Breitbandverstärker wird vermieden, daß sich von Temperaturänderungen bedingte und damit zeitlich nicht konstante Entzerrungsfehler mit zunehmender Änderung der zeitlich mittleren Verstärkung vom Planungswert vergrößern.

Änderungen der äußeren Verstärkung bringen zwar Änderungen der Verstärkung in der Gegenkopplungsschleife mit sich. Dies führt jedoch zu keinen Schwierigkeiten, die Stabilität gegen Schwingen zu sichern, da die insgesamt erforderlichen Verstärkungsänderungen auf zwei voneinander unabhängige Verstärkerblöcke aufgeteilt sind. Daher braucht die Schleifenverstärkung im Übertragungsband nicht in unerwünschter Weise abgesenkt zu werden.

Der in Figur 2 gezeigte Breitbandverstärker bzw. TF-Leitungsverstärker ist eine Kettenschaltung aus zwei jeweils in sich stark gegengekoppelten Verstärkerblöcken.

Der Vorverstärker 1 enthält zwei Transistorstufen mit den Transistoren 11 und 12, der Endverstärker 2 dagegen drei Transistorstufen mit den Transistoren 21, 23 und 25. Alle Transistoren mit Ausnahme des in der letzten Endverstärkerstufe enthaltenen Transistors 25 sind in Emitterschaltung betrieben. Der Transistor 25 der letzten Stufe des Endverstärkers 2 ist in Basisgrundschaltung geschaltet.

Die beiden Transistorstufen des Vorverstärkers 1 und die beiden letzten Stufen des Endverstärkers sind jeweils gleichstrommäßig miteinander gekoppelt. Dagegen ist sowohl zwischen dem Vorverstärker 1 und dem Endverstärker 2 sowie sowie der ersten und zweiten Stufe des Endverstärkers 2 jeweils eine gleichstrommäßige Potentialtrennung vorgesehen. Diese Potentialtrennung ist im dargestellten Beispiel im Zwischenentzerrer 7 bzw. mittels des Abblockkondensators 22 realisiert und ermöglicht es, den Arbeitspunkt der betreffenden Stufen jeweils unabhängig voneinander einzustellen. Die zur Arbeitspunkteinstellung der Verstärkerstufen erforderlichen Schaltmittel, z. B. Basisspannungsteiler, Basisvorwiderstände oder dergleichen, können in bekannter Weise ausgebildet werden und sind daher in der Figur nicht näher dargestellt. Die beiden letzten Stufen des Endverstärkers 2 erhalten mit Rücksicht auf den gewünschten geringen Leistungsverbrauch zweckmäßigerweise einen gemeinsamen Spannungsteiler zur Erzeugung der für beiden Transistoren 23 und 25 benötigten Basisvorspannung.

Die Versorgungsspannung liegt am Kondensator 8, der für die zu verstärkenden Wechselstromsignale einen Kurzschluß darstellt.

Der mit dem Pluspol der Speisespannung verbundene Anschluß ist an Nullpotential bzw. Erde gelegt. Gegebenenfalls kann anstelle des Pluspols der Minuspol an Erde liegen.

Der Eingang des Vorverstärkers 1 ist durch gemischte Gegenkopplung mit Hilfe einer verlustarmen Sparübertragerverzweigung angepaßt.

Der erste Transistor 11 des Vorverstärkers 1 wird durch die Wicklung 31 des Eingangsgabelübertragers 3 gespeist.

Zum Zwecke der gemischten Serien-Parallel-Einspeisung des Gegenkopplungssignals in den Eingang des Vorverstärkers ist eine Anzapfung der Wicklung 31 mit dem Nullpotential (Erde) verbunden und der Fußpunkt der Wicklung 31 über den ohmschen Widerstand 32 an den Ausgang des ersten Gegenkopplungsnetzwerks 5 angeschlossen.

Durch diese Art der aktiven Anpassung des Eingangswiderstandes läßt sich in bekannter Weise am Eingangsgabelübertrager 3 ein definierter Eingangsscheinwiderstand erzielen, an den ein vorgeschalteter, in der Figur nicht dargestellter Vorentzerrer angepaßt ist.

Der Ruhestrom im Transistor 11 ist so gewählt, daß sich ein minimales Rauschen ergibt. Der Vorentzerrer ermöglicht eine derartige Wahl des Ruhestromes bzw. der Verstärkung der ersten Stufe, daß der Rauschbeitrag des Transistors 12 vernachlässigbar klein ist. Ferner hat der Vorverstärker 1 eine derartige Verstärkung, daß der Rauschbeitrag des Endverstärkers 2 praktisch nicht ins Gewicht fällt.

Der zweite Transistor 12 des Vorverstärkers 1 ist kollektorseitig über den Sparübertrager 13 an Nullpotential geführt. Die Gegenkopplungsspannung des Eingangsverstärker 1 wird zwischen dem ersten Abgriff des Sparübertragers 13 und Nullpotential abgenommen und dem Gegenkopplungsnetzwerk 5 zugeführt. Durch diese Art der Auskopplung des Gegenkopplungssignals ergibt sich eine zur Ausgangsspannung des Vorverstärkers 1 proportionale Gegenkopplung.

Der erste Transistor 21 des Endverstärkers 2 ist mit seiner Basis über einen im Zwischenentzerrer 7 enthaltenen, in der Figur nicht dargestellten Abblockkondensator an den zweiten Abgriff des Übertragers 13 angeschlossen.

Zwischen dem ersten und dem zweiten Verstärkerblock ist ein zusätzliches Zwischenentzerrernetzwerk eingeschaltet. Dieser Zwischenentzerrer 7 bewirkt auch eine Potentialtrennung und kann gegebenenfalls durch einen Abblockkondensator ersetzt werden.

Die Endstufe des Endverstärkers 2 ist in Basisschaltung aufgebaut, die nicht durch starke Impedanzen Leistung verliert. Die Basisschaltung hat keine Stromverstärkung. Daher führt der Transistor 23 der Treiberstufe annähernd den gleichen Gleichstrom wie der Transistor 25 der Endstufe. Insbesondere werden die Emitter-Kollektorstrecken beider Transistoren vom gleichen Strom durchflossen, indem sie in an sich bekannter Weise in Reihenschaltung über einen Ausgang an eine Spannungsquelle angeschlossen sind.

Die Ankopplung der Treiberstufe an die Endstufe erfolgt über die Anzapfung des Sparübertragers 24, so daß Unteraussteuerung bezüglich des Stromes der Treiberstufe herrscht. Die Treiber- und die Endstufe werden insbesondere so optimiert, daß die Spannungsamplitude am Ausgang der Treiberstufe nicht zu groß ist und die Treiberstufe mit einer relativ kleinen Kollektor-Emitterspannung betrieben wird. Diese Maßnahmen führen zu einer sehr hohen Klirrdämpfung bei relativ gringem Leistungsbedarf.

Es besteht Übertragerkopplung zwischen der Treiber- und der Endstufe. Diese beiden Stufen sind galvanisch derart miteinander verbunden, daß beide vom Versorgungsgleichstrom in Serie durchflossen werden.

Der Endverstärker 2 ist am Ausgang durch gemischte Gegenkopplung mit Hilfe einer Übertragerverzweigung angepaßt. Am Eingang ist der Endverstärker 2 durch reine Seriengegenkopplung hochohmig.

Im Kollektorkreis des letzten Transistors 25 des Endverstärkers 2 liegt die Primärwicklung des Ausgangsgabelübertragers 4, dessen Sekundärwicklung den Ausgang des gesamten Breitbandverstärkers darstellt.

Zum Zwecke einer gemischten Serien-Parallel-Auskopplung des Gegenkopplungssignals ist der Fußpunkt der Primärwicklung 41 des Ausgangsgabelübertragers 4 über die Nachbildung 42 mit dem Nullpotential verbunden. Eine Anzapfung der Primärwicklung 41 ist an den Eingang des zweiten Gegenkopplungsnetzwerkes 6 geführt. Die zwischen den Ausgangsklemmen des zweiten Gegenkopplungsnetzwerkes 6 wirksame Impedanz, über die der Emitter des Transistors 21 an Nullpotential geführt ist, bewirkt für die erste Stufe des Endverstärkers eine Eigengegenkopplung.

Der Eingang des Endverstärkers ist durch Gegenkopplung hochohmig. Da der Vorverstärker somit über den als Spannungsteiler ausgebildeten Zwischenentzerrer auf einen hochohmigen Lastwiderstand arbeitet, kann der Spannungsteiler selbst relativ hochohmig sein, was für den Strombedarf der zweiten Stufe im Vorverstärker vorteilhaft ist. Dabei wirkt die erste Stufe im Endverstärker 2 als Basisstufe in der Gegenkopplungsschleife, was für die Stabilität vorteilhaft ist.

Da alle Transistorstufen über Stromzuführungswiderstände parallel an der gleichen Stromversorgungsspannung liegen, wird die maximal notwendige Spannung von der gleichstrommäßigen Serienschaltung der zweiten und der dritten Stufe im Endverstärker 2 bestimmt. Damit ist selbst bei der vorgesehenen Minimierung der für diese beiden Stufen erforderlichen Versorgungsspannung für alle vorangehenden Stufen eine ausreichende Reserve der Versorgungsspannung verfügbar. Leistungsparen heißt somit Stromsparen. Der Vorverstärker 1 ist daher so ausgelegt, daß er vornehmlich eine Spannungsverstärkung bewirkt und nur eine mäßige Stromverstärkung. Durch die der Ausgangsspannung des Vorverstärkers 1 proportionale Gegenkopplung erhält man hinsichtlich der Gegenkopplungsschleife eine Stufe in Basisschaltung und eine in Emitterschaltung, wobei sich die günstigen HF-Eigenschaften der Basisschaltung vorteilhaft auswirken. Streuimpedanzen des Eingangsgabelübertragers 3 werden nur von dem relativ geringen Basiswechselstrom des Transistors 11 der ersten Stufe durchflossen und stören daher weniger, als wenn sie im Hauptweg der Gegenkopplungsschleife liegen würden. Die günstigen Bedingungen für die Stabilität des Vorverstärkers 1 ermöglichen es, für den Vorverstärker 1 einen Ausgangsübertrager 13 einzuführen, mit dem erreicht wird, daß der durch das Gegenkopplungsentzerrer-Netzwerk gegebene Belastungswiderstand der zweiten Stufe zusätzlich hochohmiger wird. Auch dies führt zu einem geringerem Strombedarf.

## Patentansprüche

1. Gegengekoppelter Breitbandverstärker, der aus zwei in Kette geschalteten, jeweils für sich gegengekoppelten Verstärkerblöcken (1, 2) besteht und bei dem die Verstärkung sowohl mit Hilfe eines ersten Stellgliedes in Abhängigkeit von der Länge des vorangehenden Verstärkerfeldes einstellbar als auch mit Hilfe eines zweiten Stellgliedes in Abhängigkeit von der Temperatur oder dem Pegel eines empfangenen Pilots steuerbar ist, wobei jeder der beiden Verstärkerblöcke (1, 2) eines der beiden Stellglieder (50, 60) enthält und das Stellglied jeweils im Gegenkopplungszweig des betreffenden Verstärkerblockes angeordnet ist, dadurch gekennzeichnet, daß der erste Verstärkerblock (1) als temperatur- und/oder pilotgesteuerter Verstärker ausgebildet ist und daß der zweite Verstärkerblock (2) das Stellglied (60) zur Einstellung der Verstärkung in Abhängigkeit von der Länge des vorangehenden Verstärkerfeldes enthält.

2. Gegengekoppelter Breitbandverstärker nach Anspruch 1, dadurch gekennzeichnet, daß am Eingang des Breitbandverstärkers ein derart einstellbares Leitungsverlängerungsnetzwerk vorgesehen ist, daß die verbleibenden Unterschiede der Verstärkerfelddämpfung kleiner als die durch Temperatureinflüsse bedingten Dämpfungsänderungen des vorangehenden Verstärkerfeldes sind.

3. Gegengekoppelter Breitbandverstärker nach Anspruch 2, dadurch gekennzeichnet, daß der Breitbandverstärker als Leitungsverstärker eines Trägerfrequenz-Übertragungssystems V3600 ausgebildet ist.

4. Gegengekoppelter Breitbandverstärker nach einem der Ansprüche 1 bis 3, dadurch gekennzeichnet, daß der erste Verstärkerblock als gegengekoppelter, aus zwei Emitterstufen bestehender Vorverstärker (1) und der zweite Verstärkerblock als gegengekoppelter, dreistufiger Endverstärker (2) ausgebildet ist, dessen erste beiden Transistorstufen Emitterstufen sind, und daß ein Gegenkopplungssignal des Ausganges des Vorverstärkers dem Eingang eines, das eine Stellglied (50) enthaltenden ersten Gegenkopplungsnetzwerkes (5) zugeführt ist, dessen Ausgangssignal mittels gemischter Serien-Parallel-Einspeisung in den Eingang des Vorverstärkers (1) zurückgeführt ist und daß ein gemischtes Serien-Parallel-Gegenkopplungssignal des Ausganges des Endverstärkers (2) dem Eingang eines das andere Stellglied (60) enthaltende zweiten Gegenkopplungsnetzwerkes (6) zugeführt ist, dessen Ausgangssignal mittels Serienspeisung in den Eingang des Endverstärkers (2) zurückgeführt ist, wobei die Transistorstufen des Vorverstärkers und des Endverstärkers aus einer gemeinsamen Versorgungsspannungsquelle gespeist sind, daß die dritte Stufe des Endverstärkers (2) als Transistorstufe in Baisschaltung ausgebildet ist, die über die Anzapfung eines als Sparübertrager (24) ausgebildeten Zwischenübertragers derart an die zweite Transistorstufe angekoppelt ist, daß die zweite und die dritte Transistorstufe in Reihenschaltung über einen Ausgangswiderstand an die Versorgungsspannungsquelle angeschlossen sind, und daß das erste Gegenkopplungsnetzwerk (5) derart an einen Ausgangsübertrager (13) des Vorverstärkers (1) angeschlossen ist, daß der durch das erste Gegenkopplungsnetzwerk (5) gegebene Belastungswiderstand durch den Ausgangsübertrager (13) hinauftransformiert wird.

5. Gegengekoppelter Breitbandverstärker nach einem der Ansprüche 1 bis 4, dadurch gekennzeichnet, daß die Spannungsverstärkungen des Vorverstärkers und des Endverstärkers zumindest annähernd gleich groß sind.

6. Gegengekoppelter Breitbandverstärker nach einem der Ansprüche 1 bis 5, dadurch gekennzeichnet, daß das erste, insbesondere als Gegenkopplungsentzerrer ausgebildete, Gegenkopplungsnetzwerk (5) durch einen Spannungsteiler gebildet ist, der über einen Übertrager parallel zum Ausgang des Vorverstärkers (1) angekoppelt ist.

## Claims

1. A wide-band negative-feedback amplifier which consists of two amplifier units (1, 2) in cascade, each with negative-feedback, the amplification being adjustable both by a first control element in dependence upon the preceding amplifier field and also by a second control element in dependence upon temperature or the level of a received pilot, where each of the two amplifier units (1, 2) contains one of the two control elements (50, 60) and the control element is in each case arranged in the negative-feedback arm of the amplifier unit in question, characterised in that the first amplifier unit (1) is designed as a temperature-controlled and/or pilot-controlled amplifier and the second amplifier unit (2) contains the control element (60) which serves to adjust the amplification in dependence upon the length of the preceding amplifier field.

2. A wide-band negative-feedback amplifier as claimed in Claim 1, characterised in that at the input of the wide-band amplifier a line extension network is arranged which can be adjusted such that any residual differences in the amplifier field attenuation in the preceding amplifier field are smaller than the attenuation changes produced by temperature influences.

3. A wide-band negative-feedback amplifier as claimed in Claim 2, characterised in that the wide-band amplifier is designed as a line amplifier of a carrier frequency transmission system of the type V3600.

4. A wide-band negative-feedback amplifier as claimed in one of Claims 1 to 3, characterised in that the first amplifier unit is designed as a negative-feedback pre-amplifier unit (1) consisting of two common-emitter stages, and the second amplifier unit is designed as a three-stage negative-feedback output amplifier unit (2), the first two transistor stages of which are common-emitter stages, and that a negative-feedback signal from the output of the pre-amplifier unit is fed to the input of a first negative-feedback network (5) which contains a control element (50) and the output signal from which is returned, by means of mixed series-parallel input, to the input of the pre-amplifier unit (1) and that a mixed series-parallel negative-feedback signal is fed from the output of the output amplifier unit (2) to the input of a second negative-feedback network (6) which contains the other control element (6) and the output signal of which is returned by series feed to the input of the output amplifier unit (2), where the transistor stages of the pre-amplifier unit and the output amplifier unit are fed from a common supply voltage source, that the third stage of the output amplifier unit (2) is designed as a transistor stage with a common base circuit coupled via the tapping of an auto-transformer (24) serving as an intermediate coupling transformer to the second transistor stage such that the second and third transistor stages are connected, in a series arrangement, via an output resistor to the supply voltage source and that the first negative-feedback network (5) is connected to an output transformer (30) of the pre-amplifier unit (1) such that the load resistor represented by the first negative-feedback network (5) is transformed up by the output transformer (13).

5. A wide-band negative-feedback amplifier as claimed in one of Claims 1 to 4, characterised in that the voltage amplifier levels of the pre-amplifier unit and the output amplifier unit are at least approximately equal.

6. A wide-band negative-feedback amplifier as claimed in one of Claims 1 to 5, characterised in that the first negative-feedback network (5), which consists in particular of a negative-feedback equaliser, is formed by a voltage divider coupled via a transformer parallel to the output of the pre-amplifier unit (1).

**Revendications**

1. Amplificateur à large bande à contre-réaction, constitué par deux blocs amplificateurs (1, 2) branchés en série et comportant chacun une contre-réaction et dans lequel l'amplification peut être aussi bien réglée à l'aide d'un premier organe de réglage en fonction de la longueur de la précédente section d'amplification, que commandée à l'aide d'un second organe de réglage en fonction de la température ou du niveau d'un signal pilote reçu, chacun des blocs amplificateurs (1, 2) comportant l'un des deux organes de réglage (50, 60) et l'organe de réglage étant disposé respectivement dans la branche de contre-réaction du bloc amplificateur considéré, caractérisé par le fait que le premier bloc amplificateur (1) est réalisé sous la forme d'un amplificateur commandé par la température et/ou par le signal pilote et que le second bloc amplificateur (2) contient l'organe de réglage (60) servant à régler l'amplification en fonction de la longueur de la précédente section d'amplification.

2. Amplificateur à large bande à contre-réaction suivant la revendication 1, caractérisé par le fait qu'il est prévu, à l'entrée de l'amplificateur à large bande, un réseau de prolongation de lignes, qui est réglable de telle sorte que les différences résiduelles de l'affaiblissement dans la section d'amplification sont inférieures aux variations d'affaiblissement dans la précédente section d'amplification, conditionnées par des influences de la température.

3. Amplificateur à large bande à contre-réaction suivant la revendication 2, caractérisé par le fait que l'amplificateur à large bande est réalisé sous la forme d'un amplificateur de ligne d'un système de transmission à fréquence porteuse V3600.

4. Amplificateur à large bande à contre-réaction suivant l'une des revendications 1 à 3, caractérisé par le fait que le premier bloc amplificateur est réalisé sous la forme d'un préamplificateur (1) à contre-réaction constitué par deux étages montés en émetteur commun et que le second bloc amplificateur est réalisé sous la forme d'un amplificateur final à contre-réaction (2) à trois étages, dont les deux premiers étages à transistors sont des étages montés en émetteur commun, et qu'un signal de contre-réaction de la sortie du préamplificateur est envoyé à l'entrée d'un premier réseau de contre-réaction (5) contenant le premier organe de réglage (50) et dont le signal de sortie est renvoyé, au moyen d'une alimentation mixte série-parallèle, à l'entrée du préamplificateur (1) et qu'un signal de contre-réaction mixte série-parallèle de la sortie de l'amplificateur final (2) est envoyé à l'entrée d'un second réseau de contre-réaction (6) contenant l'autre organe de réglage (60) et dont le signal de sortie est renvoyé au moyen d'une alimentation série à l'entrée de l'amplificateur final (2), les étages à transistor du préamplificateur et de l'amplificateur final étant alimentées à partir d'une source commune de tension d'alimentation, que le troisième étage de l'amplificateur final (2) est réalisé sous la forme d'un étage à transistors monté en base commune, qui est accouplé par l'intermédiaire de la prise d'un transformateur intermédiaire réalisé sous la forme d'un autotransformateur (24) au second étage à transistors de telle sorte que le second et le troisième étages à transistors sont raccordés selon un montage série, par l'intermédiaire d'une résistance de sortie à la source de tension d'alimentation et que le premier réseau de contre-réaction (5) est raccordé au premier transformateur de sortie (13) du préamplificateur (1) de telle sorte que la résistance de charge, qui est déterminée par le premier réseau de contre-réaction (5), est transformée dans le sens d'une élévation par le transformateur de sortie (13).

5. Amplificateur à large bande à contre-réaction suivant l'une des revendications 1 à 4, caractérisé par le fait que les amplifications de tension du préamplificateur et de l'amplificateur final sont au moins approximativement identiques.

6. Amplificateur à large bande à contre-réaction suivant l'une des revendications 1 à 5, caractérisé par le fait que le premier réseau de contre-réaction (5), réalisé notamment sous la forme d'un correcteur de distorsions de contre-réaction, est formé par un diviseur de tension qui est accouplé en parallèle à la sortie du préamplificateur (1) par l'intermédiaire d'un transformateur.

# FIG 1

# FIG 2